# EUROPEAN PATENT APPLICATION

(11) **EP 0 707 339 A2**
(43) Date of publication of application: **17.04.1996**
(21) Application number: 95116135.5
(22) Date of filing: 12.10.1995
(51) Int. Cl.: H01L 21/321, H01L 21/768, H01L 21/3105

(54) **Method and apparatus for planarizing a layer of material on a semiconductor substrate surface**

(30) Priority: 12.10.1994 US 322095
(71) Applicant: APPLIED MATERIALS, INC., Santa Clara California 95054-3299 (US)
(72) Inventor: Raaijmakers, Ivo J., San Jose, California 95125 (US)
(74) Representative: Diehl, Hermann, Dr. Dipl.-Phys.

(57) **Abstract**

A metal or dielectric film deposited on a semiconductor substrate 8 is subsequently bombarded with ions while the substrate 8 is heated to a temperature high enough to cause reflow of the film, whereby voids in the film can be filled or the surface of the film can be planarized. The energy of the bombarding ions preferably is high enough to produce lattice defects in the film and high enough that the temperature required to achieve reflow is less than would be required in the absence of ion bombardment.

## Description

The invention relates to a process and apparatus for depositing and reflowing a layer of a material (e.g., metal or dielectric) on a semiconductor substrate surface.

Integrated circuits are fabricated on semiconductor wafers by depositing and patterning various thin films of semiconducting, insulating, and conductive materials on top of one another. Deposited metal films are used to construct, among other things, conductive paths that electrically interconnect the various devices in the integrated circuit. In current semiconductor device fabrication, the width of such metal interconnects is typically 0.8 microns or less. Interconnects are formed by depositing a metal or metal-containing film over a patterned layer of insulating film, which typically contains holes or openings that expose underlying layers or circuit elements. The deposited metal fills the holes or openings, thereby contacting the underlying layer or circuit element and thus providing an electrical connection. In more complex integrated circuits, there are often multiple metalization layers resulting in a three dimensional structure, thereby making a higher transistor density possible.

Metal films are typically deposited by physical vapor deposition, such as sputtering or evaporation. Sputtering is performed within a plasma chamber by bombarding a target (e.g. aluminum) with ionized gas atoms (e.g. Ar⁺) that are generated within the plasma. The bombarding Ar⁺ ions hit the target with such force that they cause metal atoms to be ejected. The ejected metal atoms deposit on the wafer placed nearby. In contrast, evaporation involves heating the metal target to a high enough temperature to cause the metal to evaporate. The evaporated metal atoms are directed toward the wafer, where they deposit to form a layer of metal.

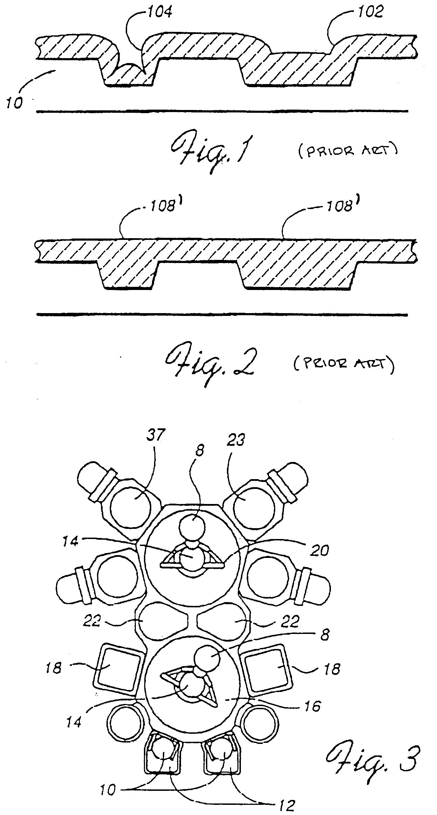

Both sputtering and evaporation produce metal layers that tend to conform to the surface geometries of the wafers onto which they are deposited. If the surface of the wafer is planar, the surface of the deposited metal layer will be planar. If the surface of the wafer contains holes or openings, the deposited metal layer will contain valleys or dips where the holes or openings exist. As shown in Fig. 1, near the edge of the hole or opening, there will be a bowed coverage 102. In addition, when the holes or openings are very small, such as 0.8 microns or less, the deposited metal tends to form an overhang near the entrance to the hole or opening. The overhang, in turn, reduces the amount of metal reaching the bottom of the hole, thereby creating what is referred to as retrograde coverage 104 within the small structure. That is, the metal deposited on the sidewalls of the hole will be thicker near the top of the wall.

The non-planar metalization surfaces and retrograde coverage tend to result in at least three significant yield-impacting problems. The deposited metal fails to make good electrical contact to the device or structure at the bottom of a hole. The retrograde coverage in the holes tends to trap contaminants which harm the devices. And the non-planar surface of the deposited metal layer interferes with efforts to deposit subsequent metal layers. Thus, it is desirable to planarize the deposited metal film to avoid these problems.

One method of planarizing a deposited film involves reflowing the metal during a reflow step which follows the deposition. During the reflow step, the wafer is heated to a temperature near the melting point of the metal. This causes the metal atoms in the deposited layer to diffuse into openings and voids, and thereby smooth out surface irregularities and fill voids beneath the surface. For aluminum, the temperature necessary to achieve an appreciable reflow of material is above 450° C and typically above 500° C.

Throughout this patent application, the term "reflow" refers to a process, such as described in the preceding paragraph, in which the semiconductor substrate is heated sufficient to cause a metal film thereon to diffuse into openings or voids in the film. The term "reflow" is not used herein to mean "second flow", nor is it intended to imply the existence of any earlier "flow" process.

Another approach, described in Lamont et al. U.S. Patent 4,756,810, is to planarize the deposited metal during the sputtering process itself. This concurrent reflow method involves bombarding the wafer with gas ions while the metal is being sputter deposited. The bombarding gas ions have sufficient energy to mobilize the deposited material and the deposited material thus spreads into any low spots in the layer.

These planarization methods have disadvantages. The high temperatures that are necessary during the subsequent reflow process exposes the wafer to stresses which can damage the devices. The high temperatures can also cause the unwanted movement of other previously deposited metal layers. In addition, if thee surface becomes contaminated before or during the transfer from the sputter deposition to the reflow step, the contamination will cause the surface to be rough. The concurrent reflow method tends to be difficult to control because changing a process parameter (such as wafer temperature, RF power, chamber pressure) affects both the deposition process and the reflow process.

The present invention intends to overcome these problems. The object is solved by the method for forming a planarized layer according to independent claim 1, 9, 17, and 25, and further by the apparatus for planarizing a deposited layer on a semiconductor substrate of independent claim 26.

Further advantages, features, aspects and details of the invention are evident from the dependent claims, the description and the accompanying drawings. The claims are intended to be understood as a first non-limiting approach of defining the invention in general terms

According to the invention, a metal or dielectric film deposited on a semiconductor substrate is subsequently bombarded with ions while the substrate is heated to a temperature high enough to cause reflow of the film, whereby voids in the film can be filled or the surface of the film can be planarized. The energy of the bombarding ions preferably is high enough to produce lattice defects in the film and high enough that the temperature required to achieve reflow is less than would be required in the absence of ion bombardment.

The invention enables reflow to be performed at lower temperatures than conventional reflow processes without ion bombardment. In addition, because my lattice defect-enhanced reflow process is performed subsequent to the deposition process, it is easier to control than a conventional reflow process in which reflow is done simultaneously with deposition. Specifically, in our invention, the deposition and reflow process steps are performed separately, hence the conditions for each process can be optimized without regard to the effect on the other process.

Other advantages and features will become apparent from the following description of the preferred embodiments and from the claims.

### Brief Description of the Drawings

Fig. 1 illustrates retrograde coverage that can occur during metal deposition in small contact holes;
Fig. 2 illustrates the desired profile of the deposited metal layer;
Fig. 3 is a diagram of a cluster tool platform in which the invention can be carried out;
Fig. 4 is a flow chart of the deposition and reflow process;
Fig. 5 shows a reflow chamber; and
Fig. 6 shows a combination chamber for performing both plasma sputtering and reflow.

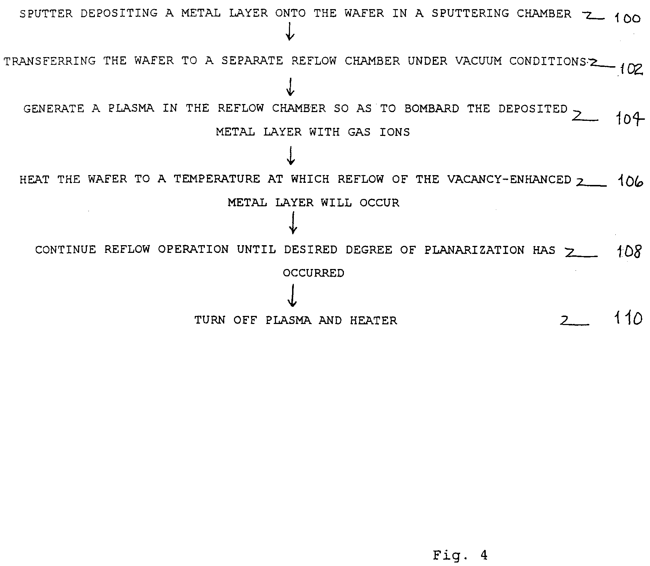

The present invention contemplates reflowing a metal or dielectric film previously deposited on a semiconductor substrate by a conventional deposition process such as physical vapor deposition (PVD) or chemical vapor deposition (CVD). Figures 3 and 4 illustrate the apparatus and process steps, respectively, for a preferred embodiment of the novel planarizing process. The process combines a reflow process with an otherwise conventional process for sputter-depositing an aluminum film.

Deposition and reflow in accordance with the invention preferably are carried out in a multichamber cluster tool system such as is illustrated in Fig. 3. An example of a commercial platform that can be modified to carry out the invention is the Endura 5500 or Centura 5200 sold by Applied Materials, Inc. of Santa Clara, California. The cluster tool, modified in accordance with the invention, contains a conventional aluminum sputter deposition chamber 23, a combination ion bombardment and reflow chamber 37, and two transfer chambers 16 and 20. If desired, the system may also include a preclean chamber 18 for cleaning the surface of the wafers prior to sputtering.

Semiconductor wafers are loaded into the system via two cassettes 10 which are mounted onto cassette loading stations 12 (see Fig. 3). A wafer from the cassette 10 is delivered into the first transfer chamber 16. The transfer chamber 16 is then pumped down to a vacuum of 0.133 Pa (10⁻³ Torr) or lower. After the desired vacuum is achieved, the wafers are passed into a second transfer chamber that is pumped to a lower pressure, e.g. 133.32·10⁻⁷ Pa to 133.32·10⁻¹¹ Pa (10⁻⁷ Torr to 10⁻¹¹ Torr), which better matches the vacuum of the sputtering chamber.

The wafers are then transferred directly into the sputtering chamber 23 or, alternatively, are first plasma etched in a preclean chamber 18, and then transferred into the sputtering chamber. Once inside the sputtering chamber, argon gas is flowed into the chamber and the vacuum is adjusted to the desired operating level. A plasma is then struck within the chamber and Al is sputter deposited onto the surface of the wafer (step 100). Sputtering continues until an aluminum layer having the desired thickness (e.g. 500 nm (500Å )) is deposited.

The foregoing steps and apparatus are completely conventional and can be implemented using any film deposition process and apparatus.

After the aluminum film is deposited on the wafer, the wafer is transferred from the sputter deposition chamber 23 to the reflow chamber 37 via the vacuum transfer chamber 20 (step 102). Meanwhile, the next wafer for sputter deposition is moved into the deposition chamber, where it will be processed while the first wafer is being processed in the reflow chamber.

With the first wafer in the reflow chamber 37, argon is flowed into the chamber and an electrical power supply excites the argon to a plasma state (step 104) while applying a negative bias voltage to the wafer or wafer pedestal. Concurrently, the wafer is heated to a temperature sufficient for reflow of the film, for example, 350-400° C for aluminum (step 106).

The negative voltage on the safer accelerates Ar⁺ ions within the plasma toward the wafer so that the ions bombard the surface of the wafer. The bombarding Ar⁺ ions can perform at least two important functions. First, they can generate lattice defects (such as vacancies) within the aluminum film. Lattice defects increase the mobility of the aluminum atoms within the film, which increases the rate of reflow when the film is heated. Second, the ion bombardment cleans the surface of the aluminum film by preventing contaminants (e.g. oxygen or nitrogen ions) from coming to rest on the surface. If contaminants are allowed to collect on the surface, they will tend to degrade the quality of the aluminum film and reduce the mobility of the aluminum atoms, thereby inhibiting the reflow of the aluminum.

The negative bias voltage applied to the wafer is selected so as to bombard the wafer with Ar⁺ ions having energies high enough to reduce the temperature required to achieve reflow of the aluminum film as compared to a conventional reflow process. Equivalently, at a given temperature somewhat below the melting point of the aluminum film, the Ar⁺ ions have energies sufficient to increase the reflow rate of the film. Preferably, the ion energies are high enough to generate lattice defects (such as vacancies) within the aluminum film. Preferably, the energies of the bombarding ions are not so high as to cause appreciable reverse sputtering of the metal layer, which would impair the quality of the aluminum surface.

For aluminum films, the energy required to displace an aluminum atom from its position within the metal lattice and thereby produce a vacancy is about 20 eV, while the energy that will sputter aluminum atoms off of the surface is about 50 eV. Thus, the desired range of operation will typically be about 20 to 50 eV, which corresponds to a wafer bias voltage of between about -20 to -50 volts relative to the plasma body. Since the plasma body typically is at a potential of about +5 to +10 volts with respect to the grounded chamber walls, the corresponding wafer bias voltage should be about -10 to -45 volts with respect to ground. If some reverse sputtering of the aluminum film can be tolerated, the wafer bias voltage may be increased above this range, such as to about -300 volts. A higher bias voltage will accelerate the reflow process. Different bias voltages would be appropriate for reflowing films of materials other than aluminum, depending on the energy required to create lattice defects in a film of that material.

While the aluminum film is subjected to ion bombardment, the reflow process is performed simultaneously. Specifically, a resistive heater 46 in the wafer support pedestal 44 heats the wafer to a temperature high enough to reflow the aluminum film. As a result of the ion bombardment of the aluminum film, the wafer need not be heated to as high a temperature to achieve reflow as would be necessary if no ion bombardment were taking place. Indeed, effective reflow can be achieved at temperatures 50-100° C less than the temperatures used in a conventional reflow process. (For Al alloys, which melt at temperature between about 575-600° C, the temperature of a conventional reflow process is at least 450° C and typically about 520° C.)

The rate of ion bombardment of the aluminum film can be increased by increasing the density of the argon plasma. A higher density plasma will produce defects within the deposited metal layer at a faster rate, and this will produce a faster reflow rate. Thus, increasing the plasma density allows the reflow process to be shortened in duration, or allows the reflow process to be performed at an even further reduced wafer temperature. Higher plasma densities can be achieved by any of a number of well known high density plasma excitation techniques. Examples of such techniques include inductively coupling energy into the plasma as disclosed in Collins et al., European Published Application 0 552 491; or using a high frequency generated plasma, as disclosed in Mintz et al. U.S. Patent No. 5,223,457; both of which patents are commonly owned by the assignee of the present invention.

The reflow process is allowed to continue long enough to fill all voids within the metal film or until the desired degree of film planarization is achieved (step 108). For a typical process this may require about 60 seconds. Of course, the required time depends on the temperature of the wafer and on the ion bombardment rate. Higher wafer temperatures, higher wafer bias voltages, and higher plasma densities produce faster reflow, thereby reducing the time required to fill voids or achieve the desired level of planarization.

When the reflow operation processing is finished, the plasma, the argon flow, and the wafer heater are turned off, and the wafer is removed from the reflow chamber (step 110).

Impurities on or in the metal film can reduce the mobility of the metal atoms so as to inhibit reflowing. Therefore, it is important to maintain the substrate in a vacuum environment free of impurities throughout the process described above, including the preceding metal deposition step. To facilitate maintaining an impurity-free environment, the wafer preferably is transferred from the deposition chamber 23 to the reflow chamber 37 within a sealed, impurity-free enclosure 20 as shown in Figure 3 so that the substrate is not exposed to ambient atmosphere. The multi-chamber cluster platform shown in Figure 3, including the sealed wafer transfer chamber 20, is available commercially from Applied Materials, Inc. as the "Endura 5500" platform, and it is described in commonly owned U.S. Patent 5,186,718, "Staged Vacuum Wafer Processing System and Method", issued to Tepman et al. There, each of the deposition chamber 23 and the reflow chamber 37 are connected to a central transfer chamber or enclosure 20 through a sealed connection. Preferably a slit-valve is located at an aperture between each of chambers 23, 37, and the enclosure 20, to enable a process environment, other than the environment in enclosure 20, to be maintained in the chambers 23, 37. Additionally, a robot arm or other wafer transfer mechanism is preferably located in the enclosure 20, to enable transfer of wafers between enclosure 20 and chambers 23, 37.

Apparatus details of the reflow chamber will be described next.

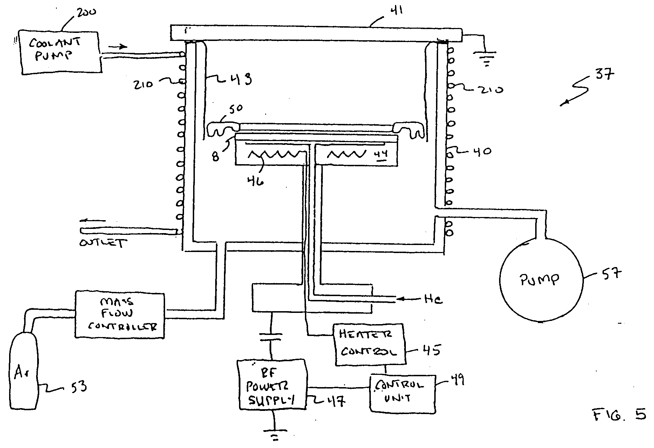

The reflow chamber 37, shown in greater detail in Figure 5, includes a chamber body 40, a top cover 41, a cylindrical shield 443, and a pedestal or platform 44 for holding the wafer 8 onto which a metal or dielectric layer has been deposited. A heater control circuit 45 is connected to an electrical resistance heater 46 within the pedestal. Both the chamber body and the shield are connected to electrical ground. An RF power supply 47, which is capacitively coupled to the platform 44 holding the wafer, generates a plasma that enhances reflow of the aluminum layer on the wafer. Both the heater control and the power supply are operated by a programmed control unit 49 to establish the operating conditions appropriate for the reflow operation.

During the reflow operation, the heater 46 is used to heat the wafer to a preselected temperature (e.g. 350-400° C for Al). To further aid in accurately controlling and stabilizing the temperature of the wafer 8 during the reflow operation, a heat transfer gas (typically Ar or He) is supplied through the platform 44 to the interface between the backside of the wafer 8 and the top of the platform 44. The heat transfer gas, which is supplied at a pressure of about 133.32 Pa (1 Torr), increases the thermal coupling between the wafer 8 and the platform 44. However, since the heat transfer gas pressure is much greater than the chamber pressure, some mechanism must be provided to prevent the wafer 8 from lifting off of the platform 44. One conventional mechanism for holding the wafer 8 in place is a clamping ring 50 which mechanically clamps the outer perimeter of the wafer 8 to the top of the platform 44. Another conventional mechanism for holding the wafer without a clamping ring is an electrostatic chuck such as described in U.S. Patent Nos. 4,771,730 and 4,565,601.

A source 53 of a sputtering process gas, such as argon, is connected to the chamber through an inlet port. The rate at which the gas is supplied to the chamber is controlled by a mass flow controller 55 and will typically be in the range of about 15-300 sccm, however, flow rates outside of this range may also be used. A vacuum pump 57, which is connected to the chamber 37 through and outlet port, establishes and maintains a vacuum (preferably a high vacuum) within the chamber 37 during reflow processing. The vacuum will be typically in the range of about 133.32·10⁻⁵ Pa to about 133.32·10⁻¹¹ Pa (about 10⁻⁵ to about 10⁻¹¹ Torr).

During the reflow operation, the RF power supply 47 generates a plasma in the argon above the wafer 8. A coupling capacitor at the output of the RF power supply 47 allows the wafer 8 to acquire a negative DC bias voltage due to accumulation of electrons from the plasma. Typically, the RF power supplied by the power supply 47 will be in the range of about 100 Watts to 700 Watts for a semiconductor wafer 8 of about 200 mm in diameter, and the negative DC bias appearing on the wafer 8 will be in the range of about 0 to -50 volts relative to ground.

Although a negative bias voltage as just described is preferred, it is within the scope of the invention to apply a pure AC voltage to the wafer 8 or pedestal 44 by dispensing with a coupling capacitor at the output of the AC power supply, in which case ion bombardment of the wafer 8 will occur only during the negative portions of the voltage waveform. Such an implementation may be desirable in order to bombard the wafer 8 in periodic pulses.

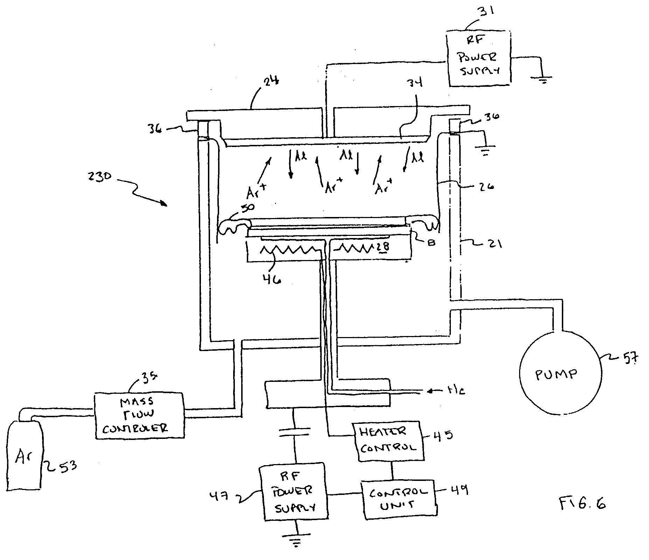

Instead of performing the ion bombardment and reflow in a separate chamber 37, it is possible to perform the reflow process in the same chamber which deposits the film. Such a combination chamber 230 (as shown in Fig. 6) would require all the components of a conventional deposition chamber, plus the additional components found in the reflow chamber 37 described above. Briefly, a conventional sputter deposition chamber 230 includes a chamber body 21, a target assembly 24, a cylindrical sidewall shield 26, and a support platform 28 for holding wafer 8. The target assembly 24 which includes a metal sputtering target 34, e.g. aluminum, is electrically isolated from the chamber body 21 and from shield 26 by insulators 36. An RF power supply 31, which is electrically coupled to the target 34, supplies the power that generates the plasma for sputtering the target 34. The additional components necessary for performing the ion bombardment include the RF power supply 47 connected to the wafer pedestal 28 and a heater control 45 connected to a heater element 46 within pedestal 28 for heating the wafer 8 to produce reflow.

Other embodiments are within the scope of the invention. For example, the sputtering process gas mixture need not be argon, but instead can include any desired mixture of gases, such as helium, neon, krypton, zenon, hydrogen, or nitrogen. Also, the wafer 8 can be heated to the reflow temperature by conventional heating apparatus other than a resistively heated pedestal 28, such as an array of radiant heat lamps.

The invention can be used to reflow a film on a semiconductor substrate composed of a metal other than aluminum, or to reflow a dielectric film. Semiconductor substrate, means a substrate composed of semiconductor material or including a layer of semiconductor material. Examples of semiconductor substrates are silicon wafers, glass substrates for liquid crystal displays having thin film transistors fabricated thereon, and silicon-on-sapphire semiconductor devices.

The invention should not be construed as limited to the specific preferred embodiments described. Modifications may be made without departing from the spirit or scope of the general inventive concept as defined by the following claims and their equivalents.

## Claims

1. A method of forming a planarized layer on a surface of a semiconductor substrate, said method comprising:
depositing a layer of material onto the surface of the substrate;
after the layer of material is deposited, bombarding the deposited layer with ions; and
heating the substrate to an elevated temperature sufficient to produce a reflow of the deposited metal layer, whereby planarization of the deposited layer is enhanced.

2. The method of claim 1 further comprising:
placing the substrate into a first chamber;
performing the depositing step in the first chamber;
after the layer of material is deposited, transferring the substrate to a second chamber;
performing the bombarding and heating steps in the second chamber.

3. The method according to at least one of the preceding claims wherein the material of the deposited layer is a metal.

4. The method according to at least one of claims 2 or 3 further comprising:
maintaining a vacuum in the first chamber while depositing the layer; and
after depositing the metal layer, transferring the substrate under vacuum conditions to the second chamber.

5. The method according to at least one of the preceding claims further comprising:
continuing the ion bombardment of the deposited metal layer at the elevated temperature until a desired level of planarization is achieved; and
after the desired level of planarization is achieved, discontinuing the ion bombardment.

6. The method according to at least one of the preceding claims wherein the step of bombarding comprises:
introducing an inert gas into the chamber; and
striking a plasma in the inert gas within the chamber, said plasma generating the gas ions which bombard the deposited metal layer.

7. The method of claim 6 wherein the inert gas is argon.

8. The method according to at least one of the preceding claims further comprising holding the substrate on a platform within the chamber and wherein the step of striking a plasma in the chamber comprises applying RF power to the platform holding the substrate.

9. The method according to at least one of the preceding claims wherein the RF power level is sufficient to cause the bombarding ions to have an energy great enough to produce defects in the deposited metal layer.

10. The method according to at least one of the preceding claims wherein the preselected energy level of the bombarding ions is high enough to achieve reflow of the deposited metal layer at temperatures below the temperatures required to achieve a comparable reflow in the absence of ion bombardment.

11. The method according to at least one of the claims 3 to 10 wherein said metal is aluminum.

12. The method according to at least one of the claims 9 to 11 wherein said energy level is above about 20 eV.

13. The method according to at least one of the claims 9 to 12 wherein said energy is below 300 eV.

14. The method according to at least one of the preceding claims wherein the elevated temperature is substantially less than the temperature at which the deposited metal reflows in the absence of any ion bombardment.

15. The method according to at least one of the preceding claims wherein the bombarding ions have sufficient energy to enhance the mobility of the atoms in the deposited layer.

16. The method according to at least one of the preceding claims wherein the bombarding ions have sufficient energy to increase the rate of reflow of the bombarding layer during the heating step.

17. A method of planarizing a deposited layer on a surface of a semiconductor substrate especially according to at least one of the preceding claims , said method comprising:
heating the substrate in a chamber to an elevated temperature;
while not depositing any new material onto the deposited layer, bombarding the deposited layer with ions to enhance the mobility of the atoms within the deposited layer so as to cause reflow of the deposited layer at the elevated temperature, whereby planarization of the deposited layer is enhanced.

18. The method according to at least one of the preceding claims wherein the material of the deposited layer is a metal.

19. The method according to at least one of the preceding claims further comprising:
while still not depositing any new material onto the deposited metal layer, continuing the ion bombardment of the deposited metal layer at the elevated temperature until a desired level of planarization is achieved; and
after the desired level of planarization is achieved, discontinuing the ion bombardment.

20. The planarizing method according to at least one of the preceding claims wherein the step of bombarding comprises:
introducing an inert gas into the chamber; and
striking a plasma in the inert gas within the chamber, said plasma generating the gas ions which are used to bombard the deposited metal layer.

21. The method of claim 20 wherein the inert gas is argon.

22. The method according to at least one of the claims 20 or 21 further comprising holding the substrate on a platform within the chamber and wherein the step of striking the plasma in the chamber comprises applying RF power to the platform holding the substrate.

23. The method according to at least one of the preceding claims further comprising the step of causing the bombarding ions to have an energy that is above a preselected energy level, wherein said preselected energy level is at least as great as the energy required to produce defects in the deposited metal layer.

24. The method according to at least one of the preceding claims wherein the preselected energy level of the bombarding ions is high enough to achieve effective reflow of the deposited metal layer at temperatures below the temperatures required to achieve a comparable reflow in the absence of ion bombardment.

25. A method of forming a planarized metal layer on a surface of a semiconductor wafer especially according to at least one of the preceding claims, said method comprising:
placing the semiconductor wafer into a first chamber which includes a sputter target made of a selected metal;
producing a vacuum in the first chamber;
introducing an inert gas in the first chamber;
striking a first plasma in the inert gas in the chamber;
sputter depositing the selected metal from the target onto the surface of the semiconductor wafer to form a deposited metal layer of metal;
after the metal layer is deposited, transferring the semiconductor wafer under vacuum conditions to a second chamber;
striking a second plasma in the second chamber;
bombarding the deposited metal layer with gas ions generated by said second plasma to enhance the mobility of the metal atoms of the metal layer;
heating the semiconductor wafer to an elevated temperature to produce a reflow of the defect-enhanced deposited metal layer;
continuing the ion bombardment of the deposited metal layer at the elevated temperature until a desired level of planarization is achieved; and
after the desired level of planarization is achieved, discontinuing the ion bombardment.

26. An apparatus for planarizing a deposited layer on a semiconductor substrate especially to perform a method according to at least one of the preceding claims, said apparatus comprising:
a vacuum chamber (23;37;230);
a platform (28;44) within the vacuum chamber (23;37;230), said platform (28;44) for holding the substrate (8);
a heater (46) within the platform (28;44) for heating the substrate (8) to an elevated temperature;
a power supply (47) for generating a plasma above the platform (28;44) in a gas that is introduced into the chamber (23;37;230); and
a control module (49) controlling the power supply (47) and the heater (46), said control unit (49) programmed to cause gas ions within the plasma to bombard the substrate (8) with energies above a preselected energy level, said preselected energy level being at least as great as the energy required to generate defects within the deposited metal layer (108'), said control module (49) further programmed to cause the heater (46) to maintain the platform (28;44) at the elevated temperature, wherein the elevated temperature is significantly less than the temperature required to achieve reflow in the absence of ion bombardment.

27. The apparatus of claim 26, wherein said layer is a metal layer.

28. The apparatus according to at least one of the claims 26 or 27 wherein said deposition chamber is plasma sputter deposition chamber (230).

29. The method according to at least one of the claims 26 to 28 wherein the bombarding ions have sufficient energy to enhance the mobility of the atoms in the deposited layer (108').

30. The method according to at least one of the claims 26 to 29 wherein the bombarding ions have sufficient energy to increase the rate of reflow of the bombarding layer during the heating step (106).
